# EUROPEAN PATENT SPECIFICATION

(11) **EP 4 157 787 B1**
(45) Date of publication and mention of the grant of the patent: **11.09.2024**
(21) Application number: 21727170.9
(22) Date of filing: 25.05.2021
(51) Int. Cl.: B81B 7/00, H03H 1/00, F16F 1/00

(54) **MEMS DEVICE WITH VIBRATION-INSULATING PLATE**
MEMS-VORRICHTUNG MIT SCHWINGUNGSISOLIERENDER PLATTE
DISPOSITIF MEMS POURVU D'UNE PLAQUE D'ISOLATION PAR RAPPORT AUX VIBRATIONS

(30) Priority: 29.05.2020 IT 202000012943
(43) Date of publication of application: 05.04.2023
(73) Proprietor: Politecnico di Milano, 20133 Milano (IT); Nanjing University Of Science And Technology, Nanjing, Jiangsu 210094 (CN)
(72) Inventor: YAO, Zhichao, Nanjing, Jiangsu 210094 (CN); ZEGA, Valentina, 63821 Porto Sant'Elpidio (FM) (IT); SU, Yan, Nanjing, Jiangsu 210094 (CN); ZHANG, Jing, Nanjing, Jiangsu 210094 (CN); CORIGLIANO, Alberto, 20155 Milano (IT)
(74) Representative: Botti & Ferrari S.p.A.
(86) International application number: PCT/EP2021/063865
(87) International publication number: WO 2021/239715

(56) References cited:
- WO-A1-2020/036632
- US-A1- 2013 025 961
- US-A1- 2020 149 604
- CHEN Y Y ET AL: "Active elastic metamaterials for subwavelength wave propagation control", ACTA MECHANICA SINICA, SPRINGER BERLIN HEIDELBERG, BERLIN/HEIDELBERG, vol. 31, no. 3, 26 May 2015 (2015-05-26), pages 349 - 363, XP035486751, ISSN: 0567-7718, [retrieved on 20150526], DOI: 10.1007/S10409-015-0402-0

## Description

### Field of the invention

The present invention relates to a MEMS device comprising at least one resonating element, and a vibration-insulating plate.

The present invention concerns vibration insulation, damping or suppression of mechanical vibrations in MEMS devices.

In general, the present invention can be applied to MEMS devices, in particular MEMS devices consisting of a plurality of solid-state components formed in or on a common substrate.

### Background art

With the advantages of small size, low-cost batch fabrication and low power consumption, Micro Electro-Mechanical Systems (MEMS) are attracting increasing interest from the scientific and industrial communities. It is then of fundamental importance to optimize their functioning and to improve their performances.

The working principle of many MEMS devices such as gyroscopes, accelerometers, micromirrors, micropumps and clocks, relies on resonating components that are driven at their own natural frequencies. Unwanted external vibrations at certain frequencies can produce spurious signals that can even compromise the right functioning of the MEMS resonant devices. For example, increased sensitivity and phase noise due to external vibration in resonant MEMS accelerometers and tuning fork gyroscopes are widely reported.

External vibration in resonant MEMS devices undermines both short-term (noise) and long-term (stability) performances. Therefore, reducing the impact of external vibrations on the MEMS resonators is critically important to improve their performance.

Several approaches have been reported to isolate MEMS resonant devices from external vibrations:
One approach for compensating the displacements induced by vibration is to introduce differential architectures in the MEMS, such as tuning fork gyroscopes (TFGs) that operate in anti-phase mode to cancel out the impact of external vibrations. Nevertheless, due to unavoidable electromechanical non-idealities, part of these signals can manifest as unwanted output changes.

Another approach is to increase the resonant frequency of the MEMS device so that it is much higher than the frequency spectrum of the environmental excitation. However, the stiffened MEMS structure requires ultra-narrow gaps to be actuated and may cause less sensitivity for the device.

Document US 9,634,227 (B1) relates to suppression of spurious modes of vibration for resonators and related apparatus and methods. A device includes a MEMS resonating structure, a substrate, and anchors between the MEMS resonating structure and the substrate. The anchors are configured to suppress the response of the at least one spurious mode of vibration.

Document US 2019/0267965 (A1) relates to a micromechanical vibro-insulator which isolates vibration of a MEMS resonator and includes a micromechanical resonator interposed between phononic bandgap mirrors.

Document US 2018/0269847 (A1) relates to an acoustic metamaterial which at least partially surrounds an active region of a resonator, the resonator including a piezoelectric material with first and second electrodes.

Document WO2020036632 (A1) relates to acoustically decoupled microelectromechanical system devices anchored upon phononic crystals. A device comprises a resonator, a handle layer, and a pedestal disposed between the resonator and the handle layer, the pedestal connecting the resonator to the handle layer.

Document US2013025961 (A1) relates to structured metamaterials that can reflect, absorb, and focus the propagation of both scalar acoustic and vector elastic waves.

Document US2020149604 (A1) relates to a monolithic phononic crystal for vibration isolation comprising: a two-dimensional array of a plurality of resonant masses, said resonant masses being connected by bridges; wherein transition regions between bridges and resonant masses have a concave shape in the plane of the two-dimensional array, respectively; wherein the resonant masses each have convex edges in the plane of the two-dimensional array; wherein the bridges are recessed with respect to the thickness of the resonant masses.

The publication "Active elastic metamaterials for subwavelength wave propagation control" of Yom Chen and G. L. Huang, June 2015 Acta Mechanica Sinica 31(3) DOI:10.1007/s10409-015-0402-0 relates to elastic metamaterials for subwavelength wave propagation control with shunted piezoelectric materials and electrorheological elastomers.

Known solutions have the drawback of limiting performances of MEMS resonators, due to residual exposure to external vibrations.

Moreover, known solutions have the drawback of being scarcely effective in suppressing unwanted vibrations in MEMS devices.

Again, known solutions for suppressing unwanted vibrations in MEMS devices have limited applications and require a tuned design for each resonator, losing robustness to process variations and environmental conditions.

It is an objective of the present invention to solve drawbacks of the prior art.

In particular, it is an object of the present invention to provide a MEMS device which is improved with respect to the prior art.

It is a further object of the present invention to insulate MEMS devices from unwanted vibrations.

It is a further object of the present invention to increase performances of MEMS resonators.

It is a further object of the present invention to provide a MEMS device which is suitable for a wide range of applications.

It is a further object of the present invention to provide a solution compatible with standard MEMS manufacturing technologies, especially within the silicon industry.

### Summary of the invention

A MEMS device according to the present invention is defined in claim 1.

An idea underlying the present invention is to interpose a vibration insulating plate between the resonating element and a substrate of the MEMS device. The vibration-insulating plate is based on a planar periodic structure providing a two-dimensional phononic crystal around and/or below the resonating element.

In that, the present invention envisages a purely mechanical solution for vibration isolation of a MEMS device, which can be fully integrated in the fabrication process through the combination of phononic crystals/metamaterials and MEMS.

The phononic crystals correspond to a planar periodic structure fully compatible with standard MEMS fabrication technologies, that shows a 3D bandgap in the frequency range of interest, i.e. natural frequencies of the resonant components of the MEMS device to isolate from external vibrations.

According to the present invention, the MEMS device as defined in claim 1 comprises at least one resonating element, and a vibration-insulating plate centrally housing the at least one resonating element. The vibration-insulating plate comprises a planar periodic structure surrounding the at least one resonating element. The planar periodic structure comprises a plurality of adjacent unit cells, each unit cell comprising a respective movable mass element suspended by spring elements. The spring elements comprise folded-beam springs.

Advantageously, the MEMS device of the present invention is capable of increasing performances of its MEMS resonators.

Advantageously, the solution of the present invention is more effective in insulating MEMS devices from unwanted external vibrations. Advantageously, the solution of the present invention is effective for a wide range of the MEMS devices and is robust to process variability and environmental conditions.

Advantageously, the solution of the present invention is fully compatible with standard MEMS manufacturing technologies, preferably providing a common co-manufactured silicon substrate.

Other features and advantages of the invention will be apparent from the following description of preferred embodiments, and from the claims.

### Brief description of the drawings

The invention will be now described with reference to the annexed drawings, provided as non-limiting examples of preferred embodiments, wherein:
- Figure 1 shows a first example of a MEMS device.
- Figure 2 illustrates a schematic section of a MEMS device.
- Figure 3 shows a unit cell in the first embodiment of MEMS device.
- Figure 4A shows a first embodiment of unit cell.
- Figure 5A and Figure 5B respectively show a top view and a perspective view of a second embodiment of a unit cell.
- Figure 6A and Figure 6B respectively show a top view and a perspective view of a third embodiment of a unit cell.
- Figure 7A and Figure 7B respectively show a top view and a perspective view of a fourth embodiment of a unit cell.
- Figure 8A and Figure 8B respectively show a top view and a perspective view of a fifth embodiment of a unit cell.
- Figure 9A and Figure 9B respectively show a top view and a perspective view of a sixth example of a unit cell.
- Figure 10 shows a second embodiment of MEMS device according to the present invention.
- Figure 11 shows a third embodiment of MEMS device according to the present invention.
- Figure 12 shows a fourth embodiment of MEMS device according to the present invention.
- Figure 13 is a diagram illustrating the vibration-insulating performances of a MEMS device according to the present invention.

In the drawings referred to in the description, the same reference numerals will designate the same or equivalent elements.

Where a plurality of alike elements exists in a same figure, only one of them may be indicated by a reference in the drawings, to improve legibility, while the other alike elements will be intended as comprised by analogy.

### Detailed Description

The present invention relates to Micro Electro-Mechanical Systems (MEMS), which are generally also related to microelectronics, micromechatronics, micromachines and microsystems.

MEMS devices are a technology of microscopic devices, particularly with moving parts. In general, individual MEMS devices are made up of components typically between 1 and 100 micrometers in size (i.e., 0.001 to 0.1 mm), and individual MEMS devices have an overall size typically ranging from 20 micrometers to a few millimeters (i.e., 0.02 to 1.0 mm or more).

In the context of the present invention, as it will be further described, each "unit cell" comprises components which have microscale features, while the overall dimension of each "unit cell" is of about one or more millimeters in a non-limitative example. As a result, the typical overall size of a MEMS device according to a non-limitative example of the present invention may be of a few millimeters, including a plurality of "unit cells".

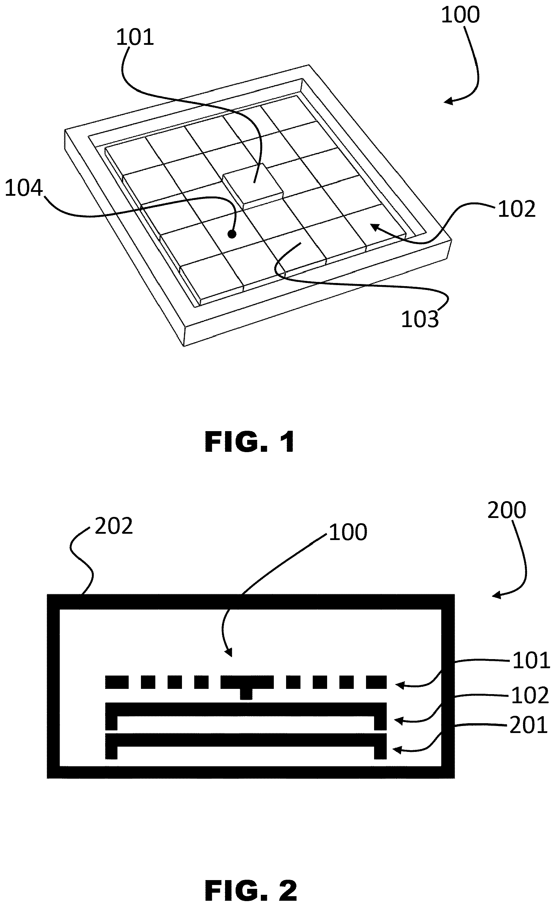

MEMS devices may merge at the nanoscale into nanoelectromechanical systems (NEMS) and nanotechnology. It is thus understood that, in the present context, MEMS or NEMS are to be considered as technically equivalent, since the teaching of the present invention could be applied to a smaller nanoscale, if required or if the technology so provides. Figure 1 shows a first embodiment of MEMS device 100 which comprises at least one resonating element 101 and a vibration-insulating plate 102 centrally housing the at least one resonating element 101.

In preferred embodiments, the least one resonating element 101 includes one or more of: MEMS gyroscopes, MEMS accelerometers, MEMS micromirrors, MEMS micropumps, MEMS clocks, or other MEMS elements. In particular, a non-limitative example of the present invention is particularly effective for resonating elements such as accelerometers and gyroscopes with a resonant frequency e.g. around 20 kHz. The MEMS device of the present invention can nonetheless be designed and tuned for various frequency ranges.

In particular, as it can be seen, the at least one resonating element 101 is housed in the vibration-insulating plate 102 in its central part. The vibration-insulating plate 102 comprises a planar periodic structure 103 surrounding the at least one resonating element 101.

In the present disclosure, the term "surround" technically indicates that the resonating element 101 applied to the vibration insulating plate 102 has at least one contact point with the vibration insulating plate 102 which is "included inside" the planar periodic structure 103, so that the latter is capable of insulating vibrations, as it will be further described.

In a preferred embodiment, the planar periodic structure 103 comprises a plurality of adjacent unit cells 104, which can overall be defined as phononic crystals and which will be further described. In a preferred but non-limiting embodiment, the at least one resonating element 101 is sized as one the unit cells 104 constituting the functional part of the vibration-insulating plate.

In particular, the planar periodic structure 103 comprises at least one complete surrounding pattern of adjacent unit cells 104, in the case of the MEMS device 100, two complete concentric surrounding patterns of adjacent unit cells 104. In a variant, even more concentric patterns could be envisaged in order to tune performances of the device.

As it will become apparent, the vibration-insulating plate 102 acts as a metamaterial or two-dimensional phononic crystal adapted to attenuate external vibration in a 3D bandgap, for the range of frequencies needed to isolate the MEMS resonator, for example 10 kHz to 30 kHz for MEMS gyroscopes.

Figure 2 illustrates an exemplary section of a MEMS device 200. The vibration-insulating plate 102 is interposed between the at least one resonating element 101 and a further silicon substrate 201 of the MEMS device 200. In addition, a package 202 protecting the MEMS device 200 is preferably provided.

The vibration-insulating plate 102 or metaplate 102 is inserted between the main silicon layer where the MEMS resonating element 101 is located and the silicon substrate 201. The metaplate 102 is then directly connected to the overlying MEMS resonator 101 in the center, and to the underlying substrate 201, preferably at its four corners, preferably by co-fabrication. The full MEMS device 200 made by the resonating element 101, the metaplate 102 and the substrate 201 is then packaged in a ceramic package 202 as usually done in MEMS devices.

When an unwanted external vibration acts on the MEMS package 202, it directly propagates to the metaplate 102 through the anchors, placed as an example at the four corners, but it does not reach the MEMS resonating element 101 thanks to the vibration isolation properties of the metaplate 102.

In that, the present invention as defined in claim 1 provides for periodic structures or phononic crystals which attenuate unwanted frequency ranges acting on the MEMS device 200.

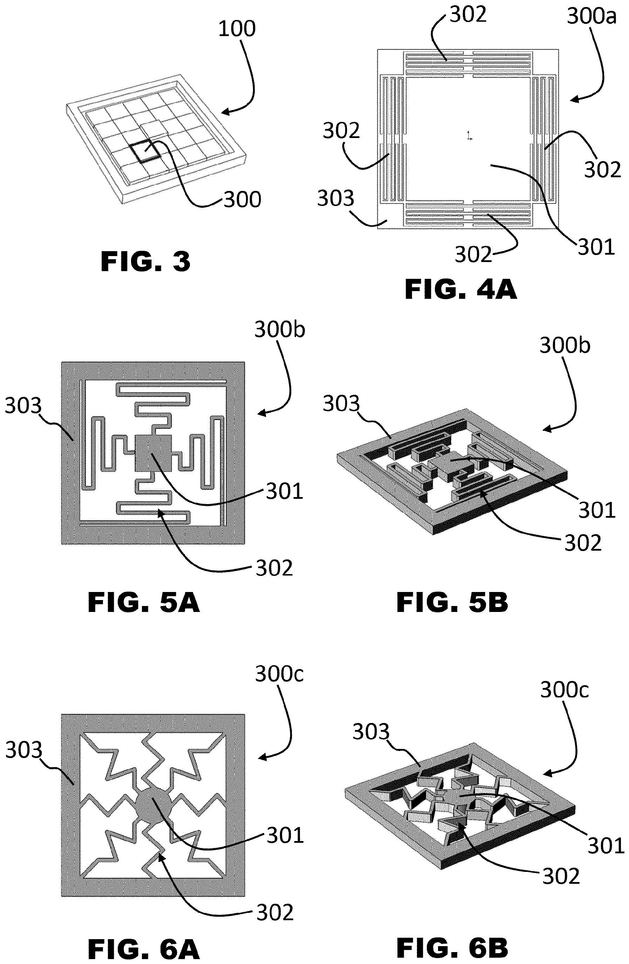

Figure 3 highlights a specific unit cell 300 in the first embodiment of MEMS device 100, within the plurality of unit cells making up the vibration-insulating plate 102. All the unit cells are preferably all alike in the vibration-insulating plate 102, but they could be of different types within a same vibration-insulating plate 102.

Figure 4A shows a first embodiment 300a of unit cell 300. The unit cell 300 comprises a respective mass element 301 suspended by spring elements 302. The spring elements 302 are elastic elements which tend to return to their original configuration after (dynamic) deformation.

The spring elements 302 are configured for mechanically connecting the respective mass element 301 to an outer frame 303 of the unit cell 300. In particular, the outer frame 303 is integral with the vibration-insulating plate 102.

In that, the unit cell 300 can be defined as unit cell of a phononic crystal. Phononic crystals are devices adapted to control the propagation of elastic/acoustic waves; they are artificial periodic structures that consist of periodically arranged scattering centers embedded in a homogeneous background matrix. One of the most important characteristics of phononic crystals is the existence of phononic bandgaps, frequency ranges where the propagation of elastic/acoustic waves is prohibited.

The metaplate 102, according to its application in MEMS resonant devices, is constituted by periodically arranged unit-cells 300. In an example, the metaplate 102 has overall dimensions of 20mm × 20mm × 0.2mm and is fabricated in single-crystal silicon through a MEMS fabrication process.

The unit cell 300 can be schematized as a 'frame-spring-mass' system, where the block 301 represents the mass and the folded beams 302 represent the springs. The springs 302 are designed to allow the movement of the mass 301 along the three orthogonal directions, thus guaranteeing a full 3D bandgap of the metaplate 102.

Figure 5A and Figure 5B respectively show a top view and a perspective view of a second embodiment 300b of unit cell 300.

As mentioned, the spring elements 302 are configured for mechanically connecting their respective mass element 301 to the outer frame 303 of the unit cell 300 which is integral with the vibration-insulating plate 102

The folded-beam springs 302 comprise respective planar spring lines, each including a plurality of angled segments. In particular, the angled segments provide complete 180° turns in the folded-beam springs 302.

Each unit cell 300 is configured for movement of its respective mass element 301 along all spatial directions. The mass element 301 is thus a movable mass element.

In particular, the mass element 301 is flat, preferably of polygonal shape, and is surrounded by a plurality of radially arranged spring elements 302, preferably on every side of the polygon.

Figure 6A and Figure 6B respectively show a top view and a perspective view of a third embodiment 300c of unit cell 300.

The spring elements 302 comprise folded-beam springs with respective planar spring lines, each including a plurality of angled segments. The mass element 301 is circular, but it could be polygonal for example octagonal as there are eight spring elements 302.

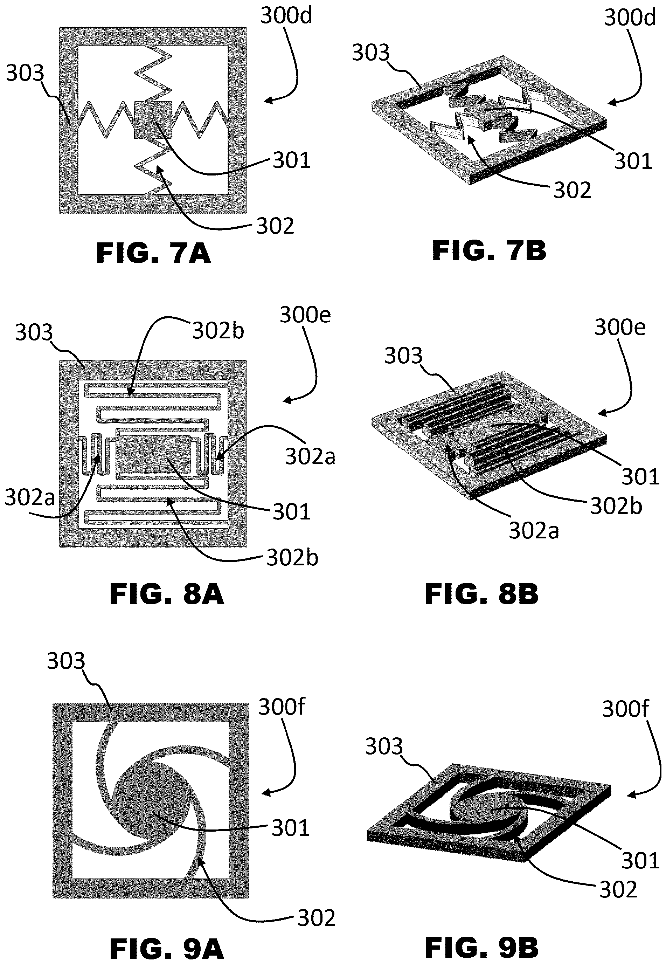

Figure 7A and Figure 7B respectively show a top view and a perspective view of a fourth embodiment 300d of unit cell 300.

The spring elements 302 comprise folded-beam springs with respective planar spring lines, each including a plurality of angled segments. In this non-limiting example, the mass element 301 is square and there are four spring elements 302. In other variants (not shown) the mass elements could have yet other shapes.

Figure 8A and Figure 8B respectively show a top view and a perspective view of a fifth embodiment 300e of unit cell 300.

The spring elements 302 comprise two slightly different designs of folded-beam springs 302a and 302b, with 180° degrees turns of different lengths. In this non-limiting example, the mass element 301 is rectangular and there is a first pair of spring elements 302a and a second pair of different spring elements 302b. In other variants (not shown) the mass elements could have yet other shapes.

Figure 9A and Figure 9B respectively show a top view and a perspective view of a sixth example 300f of unit cell 300.

The example 300f comprises springs 302 which are non-folded, i.e. with respective planar spring lines, each including a single curved or straight segment. The spring elements 302 are configured for mechanically connecting their respective mass element 301 to the outer frame 303.

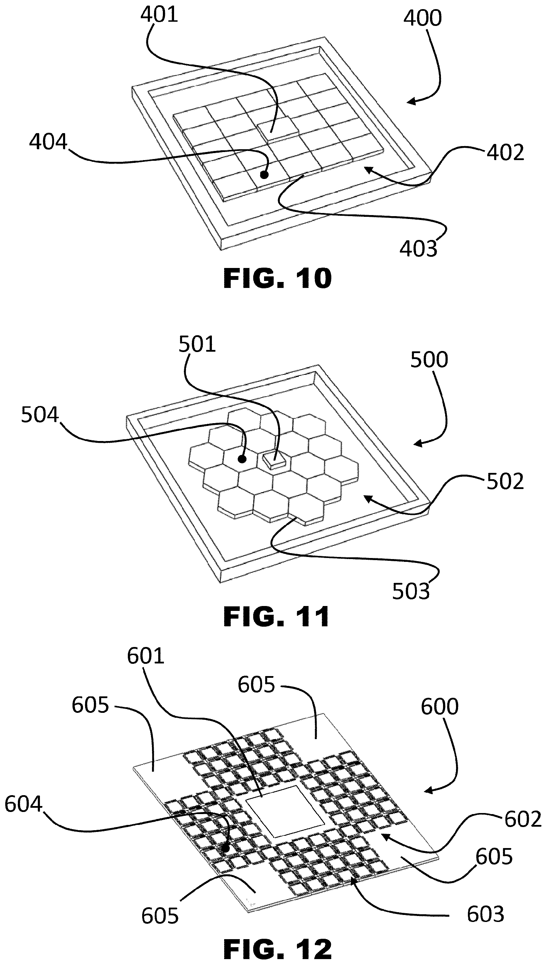

Figure 10 shows a second embodiment of MEMS device 400.

The MEMS device 400 comprises at least one resonating element 401 and a vibration-insulating plate 402 centrally housing the at least one resonating element 401 in a central part.

The vibration-insulating plate 402 comprises a planar periodic structure 403 surrounding the at least one resonating element 401. The planar periodic structure 403 comprises a plurality of adjacent unit cells 404, each unit cell 404 comprising a respective mass element 301 suspended by spring elements 302.

In particular, the planar periodic structure 403 comprises at least one complete surrounding pattern of adjacent unit cells 404, preferably two or more complete concentric surrounding patterns of adjacent unit cells 404.

In the example of MEMS device 400, the unit cells 404 are rectangular with an overall orthogonal development of the vibration-insulating plate 402.

Figure 11 shows a third embodiment of MEMS device 500.

The MEMS device 500 comprises at least one resonating element 501 and a vibration-insulating plate 502 centrally housing the at least one resonating element 501 in a central part.

The vibration-insulating plate 502 comprises a planar periodic structure 503 surrounding the at least one resonating element 501. The planar periodic structure 503 comprises a plurality of adjacent unit cells 504, each unit cell 504 comprising a respective mass element 301 suspended by spring elements 302.

In particular, the planar periodic structure 503 comprises at least one complete surrounding pattern of adjacent unit cells 504, preferably two or more complete concentric surrounding patterns of adjacent unit cells 504.

In the example of MEMS device 500, the unit cells 504 are hexagonal with an overall hexagonal development of the vibration-insulating plate 502.

Figure 12 shows a fourth embodiment of MEMS device 600.

The MEMS device 600 comprises at least one resonating element 601 and a vibration-insulating plate 602 centrally housing the at least one resonating element 601 in a central part.

The vibration-insulating plate 602 comprises a planar periodic structure 603 surrounding the at least one resonating element 601. The planar periodic structure 603 comprises a plurality of adjacent unit cells 604, each unit cell 604 comprising a respective mass element 301 suspended by spring elements 302.

In particular, the planar periodic structure 603 comprises only one complete surrounding pattern of adjacent unit cells 604, while other outer adjacent unit cells 604 do not define a closed pattern but are merely juxtaposed on the sides of the vibration-insulating plate 602. In particular, the at least one resonating element 601 in the central part is sized as a block-like plurality (specifically, four-by-four) of the unit cells 604 constituting the functional part of the vibration-insulating plate 602.

In an example, the metaplate 602 is made by a periodic repetition of a unit cell 604 that consists of a square block 301 connected to the external frame 303 through folded beams 302, properly designed to achieve a full 3D bandgap at low frequency. Four anchor points 605 and a central area are also added to the metaplate 602.

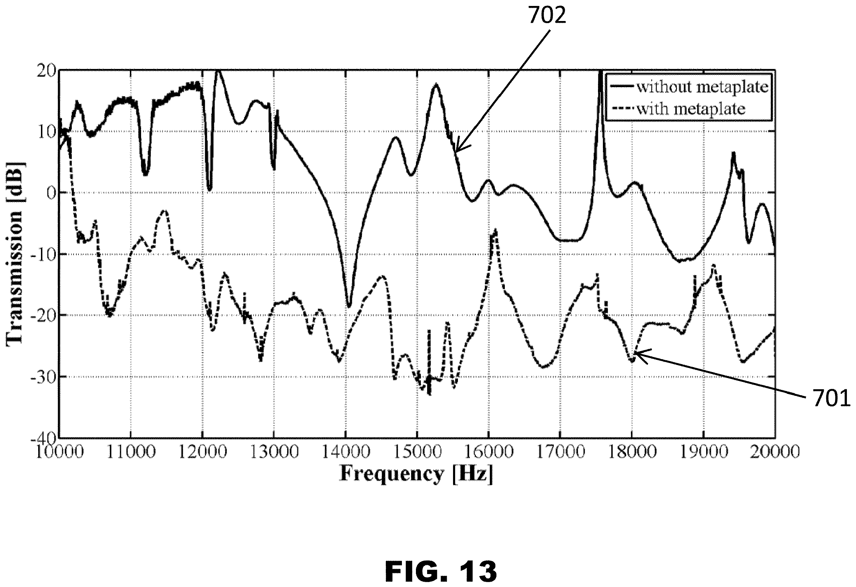

Figure 13 is a diagram illustrating the vibration-insulating performances of a MEMS device.

The figure provides a comparison of the transmission diagrams measured in experimental vibrational tests performed "with metaplate" (dashed line 701) and "without metaplate" (solid line 702).

It can be seen that the signal 702 measured in absence of the MEMS metaplate 102 is significantly higher than the signal 701 measured in the presence of the metaplate 102, thus proving the vibration isolation property of the present invention.

### Industrial applicability

The MEMS device of the present invention is fully compatible with standard MEMS fabrication processes. Advantageously, the mechanical vibration isolator or metaplate can be co-fabricated with the MEMS device.

The present invention as defined in claim 1 represents a mechanical solution for vibration isolation of MEMS resonant devices, including a vibration-insulating plate or metaplate relying on a periodic 'frame-springs-mass' system in a unit cell, which shows a complete 3D bandgap in the range of frequency of interest (i.e. resonant frequencies of the resonant devices to be isolated from external vibrations).

The metaplate shows remarkable vibration isolation properties in the frequency range 17.4 - 22.4 kHz, but it is not limited thereto. An attenuation of around -30 dB of external vibration in a wide range of frequency is then possible through the solution of the present invention. The metaplate of the MEMS device can be designed with ad-hoc bandgap properties for the resonant device one wants to isolate and be fabricated together with the device inside the package through standard MEMS fabrication process.

Although the present invention has been described in considerable detail with reference to certain preferred embodiments thereof, other variants on the device as defined by claim 1 may become apparent to those skilled in the art who consider the present description.

## Claims

1. MEMS device (100, 200, 400, 500, 600) comprising:
- at least one resonating element (101, 401, 501, 601), and
- a vibration-insulating plate (102, 402, 502, 602) centrally housing said at least one resonating element (101, 401, 501, 601);
wherein said vibration-insulating plate (102, 402, 502, 602) comprises a planar periodic structure (103, 403, 503, 603) surrounding said at least one resonating element (101, 401, 501, 601),
wherein said planar periodic structure (103, 403, 503, 603) comprises a plurality of adjacent unit cells (104, 404, 504, 604; 300), each unit cell (104, 404, 504, 604; 300) comprising a respective movable mass element (301) suspended by spring elements (302),
**characterised in that**
the said spring elements (302) comprise folded-beam springs.

2. MEMS device according to claim 1, wherein said spring elements (302) are configured for mechanically connecting said respective movable mass element (301) to an outer frame (303) of said unit cell (300), said outer frame (303) being integral with said vibration-insulating plate (102, 402, 502, 602).

3. MEMS device according to claim 1 or 2, wherein said folded-beam springs (302) comprise respective planar spring lines, each including a plurality of angled segments, preferably said angled segments providing complete 180° turns in said folded-beam springs (302).

4. MEMS device according to any one of claims 1 to 3, wherein said planar periodic structure (103, 403, 503, 603) comprises at least one complete surrounding pattern of adjacent unit cells (104, 404, 504, 604), preferably two or more complete concentric surrounding patterns of adjacent unit cells (104, 404, 504, 604).

5. MEMS device according to any one of claims 1 to 4, wherein said each unit cell (300) is configured for movement of said respective movable mass element (301) along all spatial directions.

6. MEMS device according to any one of claims 1 to 5, wherein said each unit cell (300) comprises a respective flat movable mass element (301) surrounded by a plurality of radially arranged spring elements (302).

7. MEMS device according to any one of claims 1 to 6, wherein said vibration-insulating plate (102) is interposed between said at least one resonating element (101) and a further silicon substrate (201) of said MEMS device.

8. MEMS device according to any one of claims 1 to 7, wherein said least one resonating element (101, 401, 501, 601) include one or more of: MEMS gyroscopes, MEMS accelerometers, MEMS micromirrors, MEMS micropumps, MEMS clocks.

9. MEMS device according to any one of claims 1 to 8, wherein said at least one resonating element (101, 401, 501, 601) is housed in a central part of said vibration-insulating plate (102, 402, 502, 602).

## Patentansprüche

1. MEMS-Vorrichtung (100, 200, 400, 500, 600), die Folgendes umfasst:
- mindestens ein mitschwingendes Element (101, 401, 501, 601) und
- eine schwingungsisolierende Platte (102, 402, 502, 602), die das mindestens eine mitschwingende Element (101, 401, 501, 601) zentral aufnimmt;
wobei die schwingungsisolierende Platte (102, 402, 502, 602) eine ebene regelmäßige Struktur (103, 403, 503, 603) aufweist, die das mindestens eine mitschwingende Element (101, 401, 501, 601) umgibt,
wobei die ebene regelmäßige Struktur (103, 403, 503, 603) eine Vielzahl von aneinandergrenzenden Elementarzellen (104, 404, 504, 604; 300) aufweist, wobei jede Elementarzelle (104, 404, 504, 604; 300) ein jeweiliges bewegliches Massenelement (301) aufweist, das mittels Federelemente (302) aufgehängt ist, **dadurch gekennzeichnet, dass** die Federelemente (302) Federn in Form gefalteter Balken aufweisen.

2. MEMS-Vorrichtung nach Anspruch 1, bei der die Federelemente (302) zum mechanischen Verbinden des jeweiligen beweglichen Massenelements (301) mit einem äußeren Rahmen (303) der Elementarzelle (300) gestaltet sind, wobei der äußere Rahmen (303) einstückig mit der schwingungsisolierenden Platte (102, 402, 502, 602) ist.

3. MEMS-Vorrichtung nach Anspruch 1 oder 2, bei der die Federn in Form gefalteter Balken (302) jeweilige ebenflächige Federlinien aufweisen, von denen jede eine Vielzahl von abgewinkelten Segmenten enthält, wobei die abgewinkelten Segmente vorzugsweise vollständige 180° Biegungen in den Federn in Form gefalteter Balken schaffen.

4. MEMS-Vorrichtung nach einem der Ansprüche 1 bis 3, bei der die ebene regelmäßige Struktur (103, 403, 503, 603) mindestens ein vollständig umschließendes Muster aus aneinandergrenzenden Elementarzellen (104, 404, 504, 604), vorzugsweise zwei oder mehr als zwei vollständig konzentrisch umschließende Muster aus aneinandergrenzenden Elementarzellen (104, 404, 504, 604) aufweist.

5. MEMS-Vorrichtung nach einem der Ansprüche 1 bis 4, bei der jede Elementarzelle (300) für Bewegungen des jeweiligen beweglichen Massenelements (301) in alle räumliche Richtungen gestaltet ist.

6. MEMS-Vorrichtung nach einem der Ansprüche 1 bis 5, bei der jede Elementarzelle (300) ein jeweiliges flaches bewegliches Massenelement (301) aufweist, das von einer Vielzahl von radial angeordneten Federelementen (302) umgeben ist.

7. MEMS-Vorrichtung nach einem der Ansprüche 1 bis 6, bei der die schwingungsisolierende Platte (102) zwischen dem mindestens einen mitschwingenden Element (101) und einem weiteren Silikonsubstrat (201) der MEMS-Vorrichtung eingefügt ist.

8. MEMS-Vorrichtung nach einem der Ansprüche 1 bis 7, bei der das mindestens eine mitschwingende Element (101, 401, 501, 601) eine oder mehrere der folgenden MEMS-Vorrichtungen enthält: MEMS-Gyroskope, MEMS-Beschleunigungsmesser, MEMS-Mikrospiegel, MEMS-Mikropumpen, MEMS-Uhren.

9. MEMS-Vorrichtung nach einem der Ansprüche 1 bis 8, bei der das mindestens eine mitschwingende Element (101, 401, 501, 601) in einem zentralen Teil der schwingungsisolierenden Platte (102, 402, 502, 602) untergebracht ist.

## Revendications

1. Dispositif MEMS (100, 200, 400, 500, 600) comportant :
- au moins un élément résonant (101, 401, 501, 601), et
- une plaque d'isolement contre les vibrations (102, 402, 502, 602) recevant au centre ledit au moins un élément résonant (101, 401, 501, 601),
dans lequel ladite plaque d'isolement contre les vibrations (102, 402, 502, 602) comporte une structure périodique plane (103, 403, 503, 603) entourant ledit au moins un élément résonant (101, 401, 501, 601),
dans lequel ladite structure périodique plane (103, 403, 503, 603) comporte une pluralité de cellules unitaires adjacentes (104, 404, 504, 604 ; 300), chaque cellule unitaire (104, 404, 504, 604 ; 300) comportant un élément de masse mobile (301) respectif suspendu par des éléments à ressort (302),
**caractérisé en ce que** lesdits éléments à ressort (302) comportent des ressorts à balancier replié.

2. Dispositif MEMS selon la revendication 1, dans lequel lesdits éléments à ressort (302) sont configurés pour relier mécaniquement ledit élément de masse mobile (301) respectif à un cadre extérieur (303) de ladite cellule unitaire (300), ledit cadre extérieur (303) étant solidaire de ladite plaque d'isolement contre les vibrations (102, 402, 502, 602).

3. Dispositif MEMS selon la revendication 1 ou 2, dans lequel lesdits ressorts à balancier replié (302) comportent des lignes de ressort planes respectives, chacune comprenant une pluralité de segments inclinés, lesdits segments inclinés fournissant de préférence des tours complets à 180° dans lesdits ressorts à balancier replié (302).

4. Dispositif MEMS selon l'une quelconque des revendications 1 à 3, dans lequel ladite structure périodique plane (103, 403, 503, 603) comporte au moins un motif environnant complet de cellules unitaires adjacentes (104, 404, 504, 604), de préférence deux motifs environnants concentriques complets ou plus de cellules unitaires adjacentes (104, 404, 504, 604).

5. Dispositif MEMS selon l'une quelconque des revendications 1 à 4, dans lequel chaque cellule unitaire (300) est configurée pour un mouvement dudit élément de masse mobile (301) respectif le long de toutes les directions spatiales.

6. Dispositif MEMS selon l'une quelconque des revendications 1 à 5, dans lequel chaque dite cellule unitaire (300) comporte un élément de masse mobile plat (301) respectif entouré par une pluralité d'éléments à ressort (302) agencés radialement.

7. Dispositif MEMS selon l'une quelconque des revendications 1 à 6, dans lequel ladite plaque d'isolement contre les vibrations (102) est intercalée entre ledit au moins un élément résonant (101) et un substrat de silicium supplémentaire (201) dudit dispositif MEMS.

8. Dispositif MEMS selon l'une quelconque des revendications 1 à 7, dans lequel ledit au moins un élément résonant (101, 401, 501, 601) comprend un ou plusieurs des éléments parmi : des gyroscopes MEMS, des accéléromètres MEMS, des micromiroirs MEMS, des micropompes MEMS, des horloges MEMS.

9. Dispositif MEMS selon l'une quelconque des revendications 1 à 8, dans lequel ledit au moins un élément résonant (101, 401, 501, 601) est reçu dans une partie centrale de ladite plaque d'isolement contre les vibrations (102, 402, 502, 602).
